(19) Europäisches Patentamt
European Patent Office
Office européen des brevets

(11) **EP 1 860 780 B1**

(12) **EUROPEAN PATENT SPECIFICATION**

(45) Date of publication and mention
of the grant of the patent:
**15.05.2013 Bulletin 2013/20**

(21) Application number: **06729063.5**

(22) Date of filing: **14.03.2006**

(51) Int Cl.:
*H03G 3/34* (2006.01)    *H04B 1/10* (2006.01)

(86) International application number:
**PCT/JP2006/305029**

(87) International publication number:
**WO 2006/098324 (21.09.2006 Gazette 2006/38)**

(54) **NOISE CANCELLER**

RAUSCHUNTERDRÜCKER

DISPOSITIF SUPPRESSEUR DE BRUIT

(84) Designated Contracting States:
**DE NL**

(30) Priority: **16.03.2005 JP 2005075583**

(43) Date of publication of application:
**28.11.2007 Bulletin 2007/48**

(73) Proprietor: **Pioneer Corporation
Kanagawa 212-0031 (JP)**

(72) Inventors:
• **OHASHI, Toru
Kawagoe-shi, Saitama (JP)**
• **KANNO, Hideyuki
Kawagoe-shi, Saitama (JP)**

(74) Representative: **Sajda, Wolf E. et al
Meissner, Bolte & Partner GbR
Postfach 86 06 24
81633 München (DE)**

(56) References cited:
EP-A1- 0 135 039    JP-A- 55 034 553
JP-A- 57 176 511    JP-A- 58 007 933
JP-A- 59 034 732    JP-A- 61 030 183
JP-A- 2003 069 389    JP-A- 2003 069 435
JP-A- 2004 056 173    JP-A- 2004 187 074
US-A- 4 311 963

EP 1 860 780 B1

**Description**

BACKGROUND OF THE INVENTION

The present invention relates to a noise canceller which removes a noise mixed in an input signal. In particular, the invention relates to a noise canceller as defined in the preamble of claim 1, and a processing method of a noise canceller as set forth in the preamble of claim 3.

Background Technique

In the field of signal processing technique, it is important to remove an external noise mixed in an input signal which is to be processed.

For example, a broadcast receiver or the like mounted in an automobile is apt to be affected by an external noise such as an ignition noise or the like. In view of this, a processing such as a detection and a demodulation or the like is usually not immediately applied to an intermediate frequency signal (IF signal) which is subject to a frequency conversion in a front end of a broadcast receiver. Rather, a processing such as a detection and a demodulation or the like is usually carried out after an external noise mixed in the intermediate frequency signal has been removed using a noise canceller.

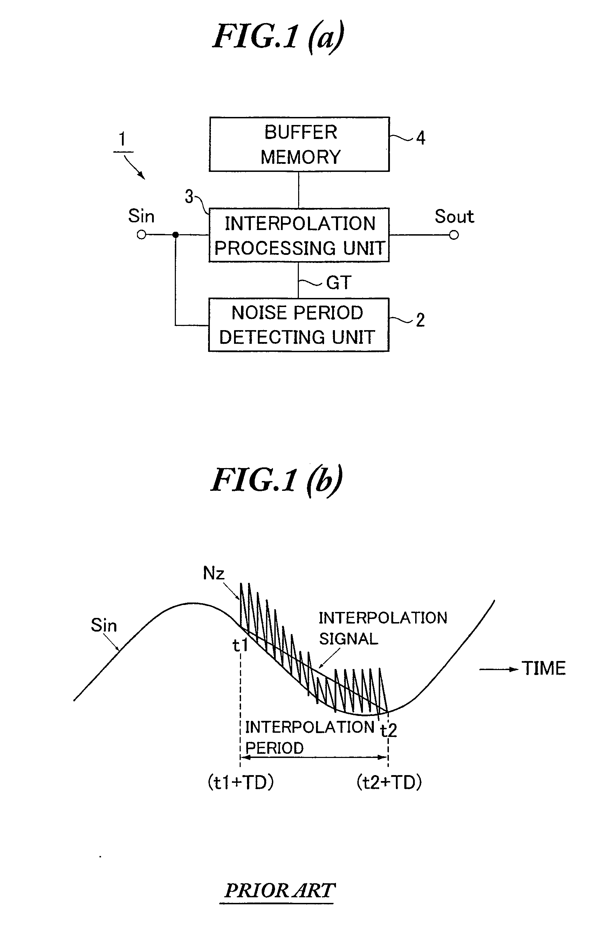

Conventionally, there has been known a noise canceller which performs a linear interpolation processing shown in Fig. 1(a).

The noise canceller 1 shown in Fig. 1(a) comprises: a noise period detecting unit 2 which detects a noise mixing period of a noise mixed in an input signal Sin; an interpolation processing unit 3 which sets an interpolation period and performs an interpolation processing for removing the noise of the input signal Sin; and a buffer memory 4 which accumulates input signals Sin corresponding to an amount of delay time TD necessary for the interpolation processing unit 3 to perform the interpolation processing and which outputs the accumulated input signals through the interpolation processing unit 3.

Namely, as shown in a waveform chart of Fig. 1 (b), when a noise Nz is not mixed in an input signal Sin, the input signals Sin accumulated in the buffer memory 4 will be outputted through the noise period detecting unit 2 without being processed to any extent. Once the noise period detecting unit 2 detects a noise mixing period lasting from a time point 1 to a time point 2, the interpolation processing unit 3 will set an interpolation period lasting from a time point (t1+TD) after the delay time TD to another time point (t2+TD), generate an interpolation signal for effecting a linear approximation between signal component of an input signal Sin at the time point t1 to signal component of an input signal Sin at the time point 2, and then output the interpolation signal within the interpolation period. Subsequently, once the interpolation period ends at a time point (t2+TD), the interpolation processing unit 3 will switch over to an input signal Sin accumulated in the buffer memory 4 and output the input signal. In this way, the output signal Sout outputted from the interpolation processing unit 3 will be input signal Sin during periods other than the interpolation period, and will become a linearly approximated interpolation signal during an interpolation period equivalent to a noise mixing period. Further, a delay time corresponding to an interpolation processing is adjusted in the buffer memory 4 and the above output signal becomes a time-serially synthesized waveform, thereby realizing the removal of the noise Nz from the input signal Sin.

However, the above-discussed conventional noise canceller which performs a linear interpolation processing has been found to have the following problems. Namely, in order to generate an interpolation signal, it is necessary to accumulate noises occurring from a noise detection point t1 to an end point t2 in the buffer memory 4. If noises occurring during a long time period exceed a storing capacity of the buffer memory 4, there would be an overflow, making it impossible to detect a noise end point t2 shown in Fig. 1(b). As a result, an undesired influence will be brought about to the interpolation processing and it will be difficult to generate an appropriate interpolation signal, rendering it impossible to sufficiently exhibit a noise removal ability, resulting in a problem that noise component will internally occur. Besides, the conventional noise canceller is such that if an overflow is to be avoided, it is necessary to increase a storing capacity of the buffer memory 4, resulting in an enlarged circuit which forms the noise canceller.

SUMMARY OF THE INVENTION

The present invention has been accomplished in view of the above conventional problem, and it is an object of the invention to provide a noise canceller and a processing method of a noise canceller which, when applying an interpolation processing to an input signal, can sufficiently exhibit a noise removal capability, thereby realizing a simplification of circuit scale.

The object underlying the present invention is solved by means of a noise canceller as defined in claim 1 and a processing method of a noise canceller as set forth in claim 3. An advantageous further development of the noise canceller according to the invention is defined in claim 2.

An invention recited in claim 1 is a noise canceller which removes a noise mixed in an input signal and outputs an output signal through storage means which delays the input signal by a predetermined time. The noise canceller comprises: noise detecting means for detecting a noise mixed in the input signal; and interpolation means which sets an interpolation period in accordance with a detection result of the noise detecting means, upon judging that said noise is a short time noise within a delay time of the storage means, generates and outputs an interpolation signal formed by linearly approximating an input signal delayed by said storage means during the interpolation period, upon judging that said noise is a long time noise exceeding the delay time of the storage means, holds an input signal delayed by the storage means and generates and outputs an interpolation signal of a constant level during a period lasting from a start point of the interpolation period until a noise end point is detected in accordance with a detection result of the noise detecting means, subsequently, generates and outputs an interpolation signal formed by linearly approximating an input signal delayed by the storage means until an end point of the interpolation period, during periods other than said interpolation period, outputs as an output signal an input signal which is a delay output of the storage means.

BRIEF DESCRIPTION OF THE DRAWINGS

Fig. 1 shows the composition and functions of a conventional noise canceller.
Fig. 2 is a block diagram showing the composition of a noise canceller formed according to an embodiment of the present invention.
Fig. 3 provides waveform graphs explaining the functions of the noise canceller shown in Fig. 2.
Fig. 4 is a block diagram showing the composition of a noise canceller of one embodiment.
Fig. 5 is a flow chart explaining an operation of the noise canceller shown in Fig. 4.

DETAILED DESCRIPTION OF THE PREFERRED EMBODIMENTS

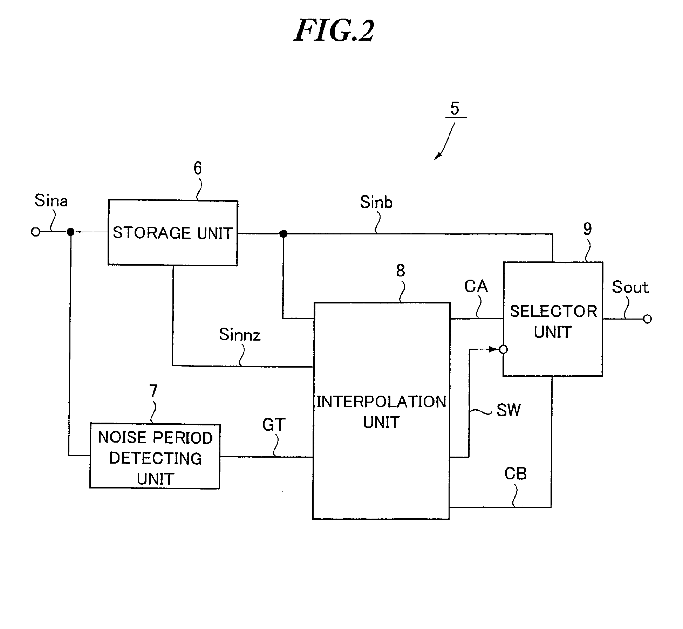

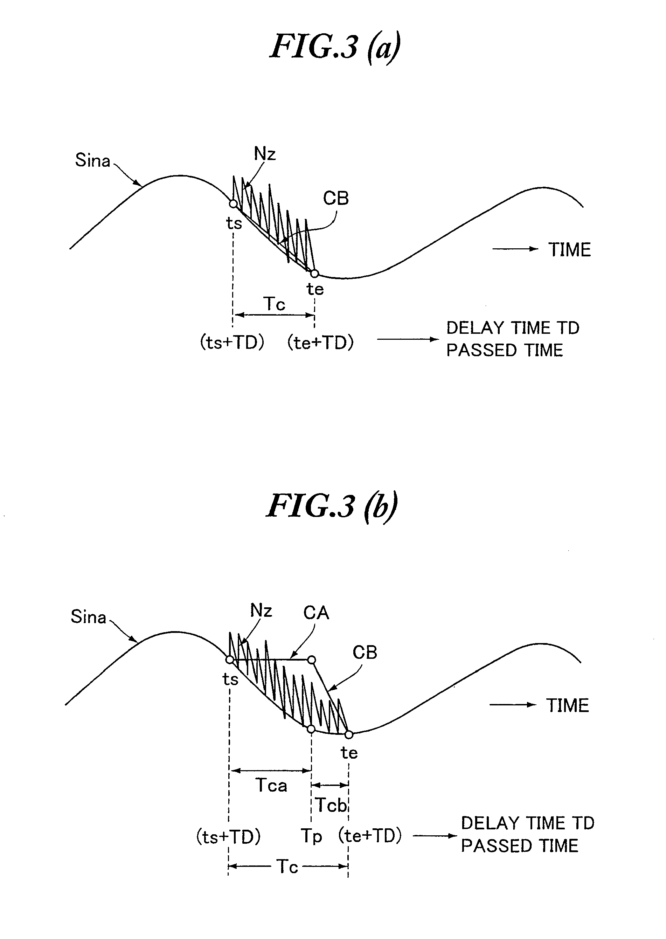

Next, description will be given to explain a preferred embodiment of the present invention with reference to Fig. 2 and Fig. 3. Fig. 2 is a block diagram showing the composition of a noise canceller formed according to one embodiment. Figs. 3 (a) and 3 (b) are waveform graphs explaining the functions of the noise canceller.

As shown in Fig. 2, the noise canceller 5 comprises a storage unit 6, a noise period detecting unit 7, an interpolation unit 8 and a selector unit 9. On the other hand, the storage unit 6 is also allowed not to be included in the noise canceller 5. For example, a digital broadcast receiver or the like is allowed to employ a buffer memory for temporarily storing reception signals or the like when performing a detection, a demodulation or the like.

The storage unit 6 buffers an input signal Sin, performs a delay by a predetermined delay time TD, and outputs the input signal Sin which has been delayed. Further, the storage unit 6 has a function of outputting as a reference signal Sinnz an input signal being buffered in response to a request from the interpolation unit 8.

The noise period detecting unit 7 detects a noise Nz currently mixed in an input signal Sina, and outputs a gate signal GT indicating a noise mixing period lasting from a noise start point ts of the noise Nz to its end point.

The selector unit 9 is a switchover means for performing a switchover in accordance with a switchover control signal SW fed from the interpolation unit 8, so that it can perform a switchover among an input signal Sinb outputted from the storage unit 6 and the interpolation signals CA, CB outputted from the interpolation unit 8, and output an elected signal as an output signal Sout.

The interpolation unit 8 judges whether a noise Nz is mixed in an input signal Sina in accordance with a gate signal GT. Once it is judged that a noise Nz has not been mixed, the selector unit 9 will be connected to the storage unit 6 in accordance with a switchover control signal SW, thus outputting as an output signal Sout an input signal Sinb which is a delay output of the storage unit 6.

On the other hand, if it is judged that a noise Nz has been mixed, it will be judged whether a noise mixing period is shorter than a delay time TD of the storage unit 6.

When a noise mixing period is shorter than a delay time TD, an interpolation period Tc will be set in which an interpolation start point will be a time point (ts+TD) which is deviated a delay time TD from a noise start point ts and an interpolation end point will be a time point (te+TD) which is deviated a delay time TD from a noise end point te. Then, an input signal Sina located immediately before the noise start point ts and an input signal Sina located immediately after the noise end point te, which have already been stored in the storage unit 6, are obtained respectively as reference signals Sinnz, thereby computing a change rate $\alpha$ in an interpolation period Tc with respect to a difference between the two reference signals Sinnz, as shown in the following equation (1). Further, after the selector unit 9 is connected to the interpolation unit 8 by virtue of switchover control signal SW, as shown in the following equation (2), a linearly approximated interpolation signal CB will be generated whose level changes at the above change rate $\alpha$ using the reference signal Sinnz equivalent to an input signal Sina located immediately before the noise start point ts as an initial value, thereby outputting the signal as an output signal Sout within the interpolation period Tc.

[Equation 1]

$$\alpha = [Sinnz(te) - Sinnz(ts)]/Tc \quad … \quad (1)$$

[Sinnz (ts) is a level of a reference signal Sinnz equivalent to an input signal Sina located immediately before the noise start point ts, Sinnz (ts) is a level of a reference signal Sinnz equivalent to an input signal Sina located immediately after the noise end point (te)].

[Equation 2]

$$CB = [Sinnz(te) - Sinnz(ts)]/Tc \quad … \quad (2)$$

[t is a passed time lasting from 0 within an interpolation period Tc]

Therefore, when a noise mixing period is shorter than a delay time TD of the storage unit 6, during an interpolation period Tc lasting from an interpolation start point (ts+TD) equivalent to a noise start point ts until an interpolation end point (te+TD) equivalent to a noise end point te, since the noise Nz is replaced by the linearly approximated interpolation signal CB, it is possible to remove the foregoing noise, as shown in Fig. 3(a).

Furthermore, as a result of judging whether the above noise mixing period is shorter than the delay time TD of the storage unit 6, if the interpolation unit 8 judges that the above noise mixing period is longer than the delay time TD of the storage unit 6, an input signal Sina already stored in the storage unit 6 and located immediately before the noise start point ts is obtained as a reference signal Sinnz, followed by outputting as an output signal Sout an interpolation signal CA having a constant level kept at the level of the reference signal Sinnz until a noise end point te is detected in accordance with a gate signal GT.

Furthermore, upon detecting the noise end point te, an input signal Sina already stored in the storage unit 6 and located immediately after the noise end point te is obtained as a reference signal Sinnz, followed by computing a difference between the reference signal Sinnz and the interpolation signal CA having a constant level. Meanwhile, computation is performed to compute a period (te+TD-tp) lasting from a time point tp at which the outputting of the interpolation signal CA having a constant level as an output signal Sout has been terminated till a time point formed by adding the delay time TD to the noise end point te.

Moreover, computation is performed to compute a change rate $\alpha$ during a period (te+TD-tp) with respect to the computed difference mentioned above, thereby outputting as an output signal Sout a linearly approximated interpolation signal CB which changes at the foregoing change rate $\alpha$ with the level of the interpolation signal CA serving as an initial value. Here, the output operation lasts from the above time point tp to another time point (te+TD).

Namely, if a noise Nz has been mixed during a long time period and it is judged that the noise mixing period is longer than a delay time TD of the storage unit 6, an interpolation signal CA having a constant level will be continuously outputted from a start point (ts+TD) of the interpolation period Tc to a time point tp. In this way, as shown in Fig. 3(b), an interpolation signal CA having a constant level is outputted as an output signal Sout within a front interpolation period Tca lasting from the interpolation start point (ts+TD) to the time point tp.

[Equation 3]

$$CA = Sinnz(ts) \quad … \quad (3)$$

Next, within a rear interpolation period Tcb lasting from the time point tp to an end point (te+TD) of the interpolation period Tc, a linearly approximated signal CB will be outputted, as shown in the following equation (4). In this way, as shown in Fig. 3(b), an interpolation signal CB will be outputted as an output signal Sout within the rear interpolation period Tcb following the front interpolation period Tca, thereby completing the processing at the end point of the interpolation period Tc.

[Equation 4]

$$CB = CA + \alpha \cdot t \quad ... \quad (4)$$

[However, t is a passed time starting from 0 within a period lasting from the time point tp to the end point (te+TD) of the interpolation period Tc]

As explained above, according to the noise canceller 5 of the present embodiment, when a noise Nz is not mixed in an input signal Sina, an input signal Sinb not containing the noise Nz will be outputted from the storage unit 6. When a short time noise Nz is being mixed, an interpolation signal CB linearly approximated during an interpolation period Tc will be outputted. On the other hand, when a long time noise Nz is being mixed, since an interpolation is performed during an interpolation period Tc by outputting a linearly approximated interpolation signal after an interpolation signal CA which has been held and has a constant level has been continuously outputted, it is possible to remove the foregoing noise.

Furthermore, when a short time noise Nz has been mixed, since an interpolation is performed by virtue of a linearly approximated interpolation signal CB whose level changes at a change rate $\alpha$ as shown in Fig. 3 (a), it is possible to prevent a high frequency noise component from mixing into the output signal Sout.

Furthermore, when a long time noise Nz has been mixed, an interpolation is performed by virtue of an interpolation signal CA having a constant level as shown in Fig. 3(b), followed by performing another interpolation by virtue of an interpolation signal CB which changes at a change rate $\alpha$ with the level of the interpolation signal CA serving as an initial value. In this way, it is possible to prevent a high frequency noise component from mixing into the output signal Sout.

Moreover, when a long time noise Nz which is longer than the delay time TD of the storage unit 6 having a limited capacity has been mixed, the front interpolation period Tca shown in Fig. 3(b) will change in response to a continuing time of the noise Nz. As a result, it is possible to properly remove the noise regardless of the length of the noise Nz. Namely, during the front interpolation period Tca, the interpolation signal CA is outputted which can be generated even if it is impossible to detect its noise end point te, and once an input signal Sina immediately after the noise end point te is stored in the storage unit 6, an interpolation signal CB based on a linear approximation will be generated and outputted using a reference signal Sinnz equivalent to the input signal Sina. As a result, it is possible to exactly remove the noise even with respect to a noise Nz continuing for a long time as compared with the storage capacity of the storage unit 6.

Then, even if there is a limitation in the storing capacity of the storage unit 6, it is still possible to perform an interpolation, so that it is not necessary to increase the storing capacity of the storage unit 6 and it is possible even to reduce the storing capacity of the storage unit 6, thereby making it possible to provide a noise canceller having a simplified structure.

In addition, the noise canceller 5 of the above-described embodiment can also be formed of a program serving as a microprocessor or a digital signal processor or the like, or can be formed of a hardware. If the noise canceller is formed of a hardware, it can be formed of a digital circuit or an analogue circuit.

[Example]

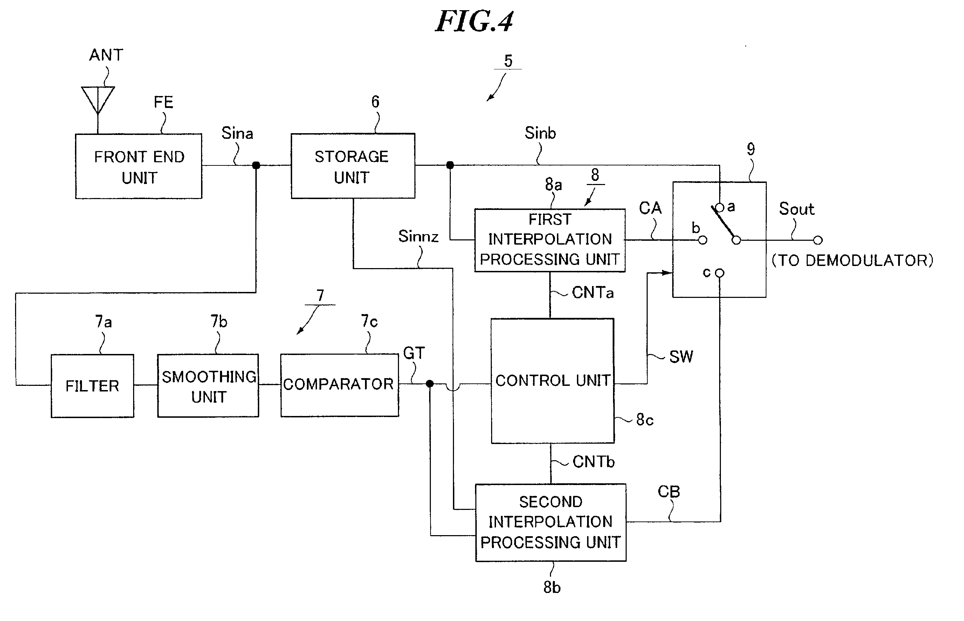

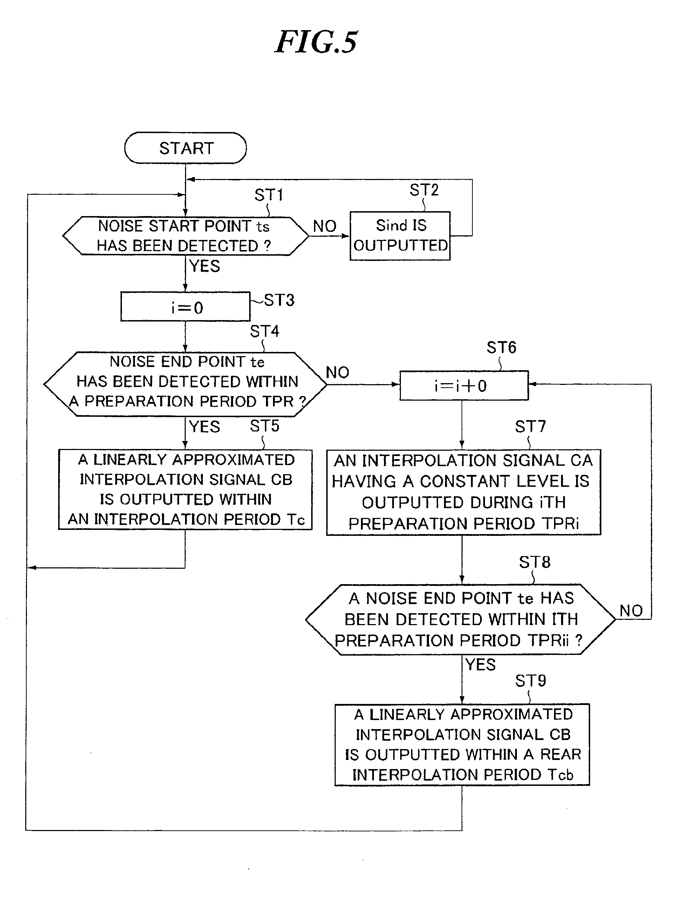

Next, description will be given to explain an example of a noise canceller provided in a vehicle radio receiver for receiving radio broadcast, with reference to Fig. 4 and Fig. 5. Fig. 4 is a block diagram showing the composition of the noise canceller of the present embodiment, using the same reference numerals to represent elements which are the same as or corresponding to those in Fig. 2. Fig. 5 is a flow chart showing an operation of the noise canceller.

As shown in Fig. 4, the noise canceller 5 of the present embodiment is formed of a microprocessor (MPU) or a digital signal processor (DSP) which carries out an executive operation according to a computer program, comprising a storage unit 6, a noise period detecting unit 7, a first interpolation processing unit 8a, a second interpolation processing unit 8b, a control unit 8c, and a selector unit 9. Here, the interpolation unit 8 shown in Fig. 2 is comprised of the first interpolation processing unit 8a and the second interpolation processing unit 8b.

Then, a baseband signal detected in the front end unit FE provided in the radio broadcast receiver is inputted as an input signal Sina, while an external noise Nz such as an ignition noise or the like is removed, thereby outputting to the demodulator an output signal Sout which is a baseband signal not containing any noise.

Namely, the front end unit FE mixes a high frequency reception signal (RF reception signal) generated in the reception antenna ANT with a turning frequency local oscillation signal to effect a frequency conversion, thereby generating an intermediate frequency signal (IF signal), limiting the frequency band of the intermediate frequency signal and amplifying the same to an amplitude level capable of receiving a signal processing, thus generating a baseband signal as a desired signal component. Then, the baseband signal is supplied as an input signal Sina to the noise period detecting unit 7 as well as to the storage unit 6.

<Composition of the storage unit 6>

The storage unit 6 is formed of a buffer memory which, by virtue of FIFO (first in first out) processing, delays an input signal Sina by a predetermined delay time TD and outputs the same, and supplies the delayed input signal Sinb to the switchover contact point a of the selector unit 9 as well as to the first interpolation processing unit 8a.
Furthermore, the storage unit 6 outputs, as a reference signal Sinnz, an input signal in FIFO processing address-specified by the second interpolation processing unit 8b to the second interpolation processing unit 8b. Namely, the storage unit 6 has a random access function.

<Composition of the noise period detecting unit 7>

The noise period detecting unit 7 comprises a filter 7a having a predetermined pass frequency band for detecting a noise, a smoothing unit 7b, and a comparator 7c having set a threshold value for level detection. Thus, the noise period detecting unit 7 detects a noise Nz mixed in an input signal Sina and supplies to the control unit 8c a gate signal GT indicating a noise start point ts at which the signal component of the input signal Sina changes over to a noise Nz and an end point te of the noise Nz. Therefore, when a noise Nz has been mixed in a long time period, a gate signal GT indicating a long interval between a noise start point ts and its end point te will be supplied to the control unit 8c. On the other hand, when a short time noise Nz has been mixed, a gate signal GT indicating a short interval between a noise start point ts and its end point te will be supplied to the control unit 8c.

<Composition of control unit 8c>

The control unit 8c detects, as a noise mixing period, a period lasting from the noise start point ts to the noise end point ts, in accordance with the gate signal GT. Then, the control unit 8c sets, as an interpolation period Tc, a period lasting from a time point (ts+TD) at which a delay time TD has passed from the noise start point ts to a time point (te+TD) at which a delay time TD has passed from the noise end point te.
Furthermore, the control unit 8c, during periods other than an interpolation period Tc, connects the selector unit 9 to the switchover contact point a in accordance with a switchover control signal SW, thereby outputting as an output signal Sout the input signal Sinb which is a delay output from the storage unit 6 and does not contain noise Nz.
Moreover, the control unit 8c, upon detecting a noise start point ts in accordance with a gate signal GT, judges whether a noise end point te has been detected within a predetermined preparation period (shorter than a delay time TD) TPR lasting from a noise end point ts. Once it is judged that the noise end point te has been detected, the selector unit 9 will be connected to the switchover contact point c in accordance with a switchover control signal SW at the start point (ts+TD) of the interpolation period Tc. Meanwhile, the second interpolation processing unit 8b is controlled in accordance with a second control signal CNTb, thereby starting an interpolation processing for generating an interpolation signal CB and outputting as an output signal Sout the interpolation signal CB until an end point (te+TD) of the interpolation period Tc. Then, at an end point (te+TD) of the interpolation period Tc, the selector unit 9 is again connected to the switchover contact point a in accordance with a switchover control signal SW, thereby outputting as an output signal Sout an input signal Sinb which is a delay output of the storage unit 6.
Moreover, as a result of judging whether a noise end point te has been detected within the aforementioned preparation period TPR lasting from a noise end point ts, once the control unit 8c judges that a noise end point te fails to be detected, it will be judged that a long time noise has been mixed and the first interpolation processing unit 8a will be controlled by virtue of the first control signal CNTa. As a result, an interpolation processing will be started from a start point (ts+TD) of the interpolation period Tc and at the same time the selector unit 9 will be again connected to the switchover contact point b by virtue of a switchover control signal SW, thereby outputting as an output signal Sout an interpolation signal CA generated in the first interpolation processing unit 8a. Then, within a preparation period (iXTPR) which is an integer i multiples of the preparation period TPR, once a noise end point te is detected, the interpolation processing of the first interpolation processing unit 8 will be terminated at a time point at which a delay time TD has passed from the noise end point te.
Further, at the foregoing time point tp, the control unit 8c terminates the interpolation processing of the first interpolation processing unit 8a, and at same time connects the selector unit 9 to the switchover contact point b by virtue of the switchover control signal SW. Moreover, the control unit 8c controls the second interpolation processing unit 8b by virtue of the second control signal CNTb, thereby starting an interpolation processing for generating an interpolation signal CB and outputting as an output signal Sout the interpolation signal CB during a time period lasting from the time point tp till an end point (te+TD) of the interpolation period Tc. Then, at the end point (te+TD) of the interpolation period Tc, the control unit 8c will connect the selector unit 9 to the switchover contact point a by virtue of the switchover control signal SW and will output as an output signal Sout an input signal Sinb which is a delay output of the storage unit 6.
Namely, if a noise Nz has not been mixed in an input signal Sinb, i.e., during periods other than an interpolation period Tc, the control unit 8c will output as an output signal Sout an input signal Sinb not containing noise. Further, when a noise Nz of a shorter time than the preparation period TPR has been mixed, an interpolation signal CB generated in the second interpolation processing unit 8b will be outputted as an output signal Sout during the interpolation period Tc. On the other hand, when a noise of a longer time than the preparation period TPR has been mixed, the interpolation signal CA generated in the first interpolation processing unit 8a will be outputted as an output signal Sout during a front interpolation period Tca lasting from the start point (ts+TD) of the interpolation period Tc to a time point tp. Subsequently, the interpolation signal CB generated in the second interpolation processing unit 8b will be outputted as an output signal Sout during a rear interpolation period Tcb lasting from the time point tp to an end point (te+TD) of the interpolation period Tc.

When a noise Nz of a longer time than the preparation time TPR has been mixed as described above, the first interpolation processing unit 8a will generate and then output an interpolation signal CA in accordance with an interpolation control signal CNTa supplied from the control unit 8c. Namely, once a time point at which a delay time TD has passed from a noise start point ts (i.e., a start point of the interpolation period Tc) is specified by virtue of an interpolation control signal CNTa, the first interpolation processing unit 8a will gate-hold the level of a signal component located immediately before the noise start point ts and already obtained by virtue of the input signal Sinb fed from the storage unit 6, and continue to output a held interpolation signal CA having a constant level until an end point tp of the foregoing front interpolation period Tca, thus completing the processing.

When a noise Nz of a shorter time than the preparation period TPR has been mixed as described above, the second interpolation processing unit 8b will generate and thus output an interpolation signal CB in accordance with an interpolation control signal CNTb supplied from the control unit 8c.

Namely, during the preparation period TPR the second interpolation processing unit 8b detects a noise start point ts and a noise end point te from a gate signal GT, obtains, as the respective reference signals Sinnz, an input signal Sina located immediately before the noise start point ts and another input signal Sina located immediately after the noise end point te which have all been stored in the storage unit 6, followed by performing a computation similar to that shown in the foregoing equation (1), thereby calculating in advance a change rate $\alpha$ within the interpolation period Tc with respect to a difference between the two reference signals Sinnz. Then, once an interpolation control signal CNTa is supplied from the control unit 8c, a computation similar to that shown in the foregoing equation (2) will be performed, thereby generating a linearly approximated interpolation signal CB whose level changes at the change rate $\alpha$ with its initial value being a reference signal Sinnz equivalent to an input signal Sina located immediately before the noise start point ts, thus outputting the signal as an output signal Sout within the interpolation period Tc.

Moreover, when a noise Nz of a longer time than the preparation time TPR has been mixed as described above, after the first interpolation processing unit 8a has performed an interpolation processing, the second interpolation processing unit 8b will generate and then output an interpolation signal CB within a rear interpolation period Tcb, in accordance with an interpolation control signal CNTb supplied from the control unit 8c. Namely, within the front interpolation period Tca before the time point tp which is the start point of the rear interpolation period Tcb is specified by the interpolation control signal CNTb, the second interpolation processing unit 8b detects the noise end point te from the gate signal GT, thereby obtaining as a reference signal Sinnz an input signal Sina already stored in the storage unit 6 and located immediately after the noise end point te. Then, during the front interpolation period Tca, the level of an interpolation signal CA being outputted from the first interpolation processing unit 8a is detected through the control unit 8c, followed by calculating in advance a difference (Sinnz-CA) between the level of the interpolation signal CA and the level of the reference signal Sinnz obtained as described above. Subsequently, the second interpolation processing unit 8b, upon being instructed by the foregoing time point tp and the rear interpolation period Tcb, calculates a change rate $\alpha$ in the rear interpolation period Tcb with respect to the foregoing difference (Sinnz-CA) calculated in advance, takes the level of the interpolation signal CA as an initial value at the time point tp so as to generate an interpolation signal CB by performing the same processing as shown in the above equation (4), thereby outputting the above interpolation signal as an output signal Sout within the rear interpolation period Tcb.

Next, description will be given to explain an operation of the noise canceller 5 of the present embodiment having the above-described configuration, with reference to a flowchart shown in Fig. 5.

At step ST1 shown in Fig. 5, the control unit 8c judges whether a noise start point ts has been detected, and connects the selector unit 9 to the switchover contact point <u>a</u> at step ST2 until it is judged that a noise start point ts has been detected, thereby outputting as an output signal Sout an input signal not containing noise. On the other hand, once it is judged that a noise start point ts has been detected, the process will shift from the step ST1 to

step ST3.

At step ST3, after the control unit 8c sets the turn <u>i</u> of the preparation period TPR beginning from ts at 0, the process proceeds to step ST4.

At step ST4, the control unit 8c, during the preparation period TPR following the noise start point ts, judges whether a noise end point te has been detected. If yes, the process proceeds to step ST5. If not, the process proceeds to step ST6.

At step ST5, the control unit 8c connects the selector unit 9 to the switchover contact point c by virtue of the switchover control signal SW, and at the same controls the second interpolation processing unit 8b by virtue of the second control signal CNTb. Further, an interpolation signal CB is generated and outputted as an output signal Sout until the end point (ts+TD) of the interpolation period Tc, and the selector unit 9 is connected to the switchover contact point a at the end point (te+TD) of the interpolation period TC, followed by repeating the process beginning with step TS1. In this way, by virtue of the process from step ST3 to step ST5, a short time noise Nz will be replaced by an interpolation signal CB, thereby effecting a desired noise removal.

Next, upon proceeding to the step ST6, the control unit 8c will increment the turn i by 1, thereby setting a first preparation period TPR which continues from the noise start point ts. Then, at step ST7, the selector unit 9 is connected to the switchover contact point b by virtue of the switchover control signal SW, while at the same time allowing the first interpolation processing unit 8a to start the generation and the outputting of an interpolation signal CA by virtue of the interpolation control signal CNTa. Then, at step ST8, within the first preparation period TPR, it is judged whether the control unit 8c has detected a noise end point te. If yes, the process proceeds to step ST9. Subsequently, at time point tp at which it is judged that a noise end point te has been detected, the selector unit 9 is connected to the switchover contact point c by virtue of the switchover control signal SW, while the second interpolation processing unit 8b is allowed to start the generation and the outputting of a linearly approximated interpolation signal CB by virtue of the interpolation control signal CNTb, thereby outputting as an output signal Sout the interpolation signal until the end point (te+TD) of the interpolation period Tc. Then, at the end point (te+TD) of the interpolation period Tc, the selector unit 9 is connected to the switchover contact point a, while the process beginning with step ST1 is repeated.

On the other hand, at step ST8, within the first preparation period TPR, if it is judged that the control unit 8c fails to detect the noise end point te, the control unit 8c will proceed to step ST6 and further increment the turn i, thereby continuing to set the second preparation period TPR and continuing the processing of step ST7, thus outputting the interpolation signal CA of the first interpolation processing unit 8a. Afterwards, preparation periods TPR are successively extended and the output of the interpolation signal CA is continued until the end point te can be detected at the step ST8. Then, once the noise end point te is detected, the process proceeds to step ST9, thereby outputting as an output signal Sout a linearly approximated interpolation signal CB generated in the second interpolation processing unit 8b until the end point (te+TD) of the interpolation period Tc. Subsequently, the selector unit 9 is connected to the switchover contact point a while the process beginning with step ST1 is repeated.

In this way, upon carrying out the processing from step ST6 to step ST9, the front interpolation period Tca will properly change in response to a time length of a noise Nz until the noise end point te is detected by the control unit 8c. Then, within the front interpolation period Tca, an interpolation signal CA having a constant level will become an output signal Sout and be outputted. Further, an interpolation is carried out by virtue of a linearly approximated interpolation signal CB until an end point (namely, an end point of an interpolation period Tc) of the rear interpolation period Tcb located subsequent to the end point tp of the foregoing front interpolation period Tca.

As explained above, according to the noise canceller 5 of the present embodiment, it is possible to remove a noise Nz mixed in a baseband signal generated in a radio broadcast receiver.

Furthermore, even if there is a limitation in the storing capacity of the storage unit 6 as described with regard to the foregoing embodiment, since it is possible to perform an interpolation processing, it is not necessary to increase the storing capacity of the storage unit 6. Further, since it is allowed to reduce the storing capacity of the storage unit 6, it becomes possible to provide a noise canceller having a simplified structure. In particular, since it is possible to form a simplified structure as described above, the noise canceller of the present invention may be properly used in a vehicle radio receiver or a portable radio receiver, thereby exhibiting an excellent advantage.

As described above with reference to Fig. 5, the noise canceller 5 of the present embodiment sets a period shorter than a delay time TD as each preparation period TPR. When a noise start point ts and a noise end point te are both detected within each preparation period TPR, it will be judged that a noise at this time is a short time noise Nz. On the other hand, when it is not possible to detect a noise start point te, it will be judged that a noise at this time is a long time noise Nz. In this way, it is possible to effect a switchover between different interpolation processings. However, it is also possible to have a modified example in which if the first and second interpolation processing units 8a and 8b are formed of circuits which can process at a high speed, each preparation period TPR can be set at a period equal to a delay time TD.

## Claims

1.   A noise canceller (5) which removes a noise mixed in an input signal and outputs an output signal through storage means (6) which delays the input signal by a predetermined time,

the noise canceller (5) comprising:

- noise detecting means (7) for detecting a noise mixed in the input signal; and
- interpolation means (8) which sets an interpolation period in accordance with a detection result of the noise detecting means (7), and upon judging that the noise is a short time noise within a delay time of the storage means (6), generates and outputs an interpolation signal formed by linearly approximating an input signal delayed by the storage means 86) during the interpolation period,

**characterized in that** the interpolation means (8)

- upon judging that the noise is a long time noise exceeding the delay time of the storage means (6), holds an input signal delayed by the storage means (6) and generates and outputs an interpolation signal of a constant level during a period lasting from a start point of the interpolation period until a noise end point is detected in accordance with a detection result of the noise detecting means (7),
- subsequently, generates and outputs an interpolation signal formed by linearly approximating an input signal delayed by the storage means (6) until an end point of the interpolation period, and
- during periods other than the interpolation period, outputs as an output signal an input signal which is a delay output of the storage means (6).

2. The noise canceller according to claim 1,
wherein the storage means (6) and the noise detecting means (7) receive as the input signal a reception signal generated in a receiver, and
wherein the interpolation means (8) judges a level of the input signal in accordance with a reception sensitivity signal detected in the receiver.

3. A processing method of a noise canceller (5) which removes a noise mixed in an input signal and outputs an output signal through storage means (6) which delays the input signal by a predetermined time,
the processing method comprising the following steps:

- a noise detecting step (7) for detecting a noise mixed in the input signal; and
- an interpolation step which sets an interpolation period in accordance with a detection result of the noise detecting step, and upon judging that the noise is a short time noise within a delay time of the storage means (6), generates and outputs an interpolation signal formed by linearly approximating an input signal delayed by the storage means (6) during the interpolation period,

**characterized in that** the method further comprises the following steps:

- upon judging that the noise is a long time noise exceeding the delay time of the storage means (6), holds an input signal delayed by the storage means (6) and generates and outputs an interpolation signal of a constant level during a period lasting from a start point of the interpolation period until a noise end point is detected in accordance with a detection result of the noise detecting step,
- subsequently, generates and outputs an interpolation signal formed by linearly approximating an input signal delayed by the storage means (6) until an end point of the interpolation period, and
- during periods other than the interpolation period, outputs as an output signal an input signal which is a delay output of the storage means (6).

**Patentansprüche**

1. Rauschunterdrücker (5), der in ein Eingangssignal gemischtes Rauschen entfernt und ein Ausgangssignal durch eine Speichereinrichtung (6) abgibt, die das Eingangssignal um eine vorbestimmte Zeit verzögert,
wobei der Rauschunterdrücker (5) folgendes aufweist:

- eine Rauscherfassungseinrichtung (7) zum Detektieren von in das Eingangssignal gemischtem Rauschen; und
- eine Interpolationseinrichtung (8), die eine Interpolationsperiode in Abhängigkeit von einem Erfassungsergebnis der Rauscherfassungseinrichtung (7) vorgibt und bei der Beurteilung, daß es sich bei dem Rauschen um kurzzeitiges Rauschen innerhalb einer Verzögerungszeit der Speichereinrichtung (6) handelt, ein Interpolationssignal erzeugt und abgibt, das durch lineares Approximieren eines Eingangssignals gebildet wird, das durch die Speichereinrichtung (6) während der Interpolationsperiode verzögert wird,

**dadurch gekennzeichnet,**
**daß** die Interpolationseinrichtung (8)

- bei der Beurteilung, daß es sich bei dem Rauschen um Langzeit-Rauschen handelt, das die Verzögerungszeit der Speichereinrichtung (6) übersteigt, ein durch die Speichereinrichtung (6) verzögertes Eingangssignal hält und ein Interpolationssignal mit einem konstanten Pegel während einer Periode erzeugt und abgibt, die von einem Startpunkt der Interpolationsperiode andauert, bis ein Rauschendpunkt in Abhängigkeit von einem Erfassungsergebnis der Rauscherfassungseinrichtung (7) detektiert wird,
- anschließend ein Interpolationssignal erzeugt und abgibt, das durch lineares Approximieren eines Eingangssignals gebildet wird, das durch die Speichereinrichtung (6) bis zu einem Endpunkt der Interpolationsperiode verzögert wird, und
- während Perioden mit Ausnahme der Interpolationsperiode, als Ausgangssignal ein Eingangssignal abgibt, das ein Verzögerungsausgangssignal der Speichereinrichtung (6) ist.

2. Rauschunterdrücker nach Anspruch 1,
wobei die Speichereinrichtung (6) und die Rauscherfassungseinrichtung (7) als Eingangssignal ein in einem Empfänger erzeugtes Empfangssignal erhalten, und
wobei die Interpolationseinrichtung (8) einen Pegel des Eingangssignals in Abhängigkeit von einem in dem Empfänger detektierten Empfangsempfindlichkeitssignal beurteilt.

3. Verarbeitungsverfahren eines Rauschunterdrückers (5), der in ein Eingangssignal gemischtes Rauschen und ein Ausgangssignal durch eine Speichereinrichtung (6) abgibt, die das Eingangssignal um eine vorbestimmte Zeit verzögert,
wobei das Verarbeitungsverfahren folgende Schritte aufweist:

- einen Rauscherfassungsschritt (7) zum Detektieren von in das Eingangssignal gemischtem Rauschen; und
- einen Interpolationsschritt, der eine Interpolationsperiode in Abhängigkeit von einem Erfassungsergebnis des Rauscherfassungsschritts vorgibt und bei der Beurteilung, daß es sich bei dem Rauschen um kurzzeitiges Rauschen innerhalb einer Verzögerungszeit der Speichereinrichtung (6) handelt, ein Interpolationssignal erzeugt und abgibt, das durch lineares Approximieren eines Eingangssignals gebildet wird, das durch die Speichereinrichtung (6) während der Interpolationsperiode verzögert wird,

**dadurch gekennzeichnet,**
**daß** das Verfahren ferner folgende Schritte aufweist:

- bei der Beurteilung, daß es sich bei dem Rauschen um Langzeit-Rauschen handelt, das die Verzögerungszeit der Speichereinrichtung (6) übersteigt, wird ein durch die Speichereinrichtung (6) verzögertes Eingangssignal gehalten und ein Interpolationssignal mit einem konstanten Pegel während einer Periode erzeugt und abgegeben, die von einem Startpunkt der Interpolationsperiode andauert, bis ein Rauschendpunkt in Abhängigkeit von einem Erfassungsergebnis des Rauscherfassungsschrittes detektiert wird,
- anschließend wird ein Interpolationssignal erzeugt und abgegeben, das durch lineares Approximieren eines Eingangssignals gebildet wird, das durch die Speichereinrichtung (6) bis zu einem Endpunkt der Interpolationsperiode verzögert wird, und
- während Perioden mit Ausnahme der Interpolationsperiode, wird als Ausgangssignal ein Eingangssignal abgegeben, das ein Verzögerungsausgangssignal der Speichereinrichtung (6) ist.

**Revendications**

1. Dispositif suppresseur de bruit (5) qui supprime un bruit mélangé dans un signal d'entrée et délivre un signal de sortie via des moyens de stockage (6) qui retardent le signal d'entrée d'un temps prédéterminé,
le dispositif suppresseur de bruit (5) comprenant:

- un moyen de détection de bruit (7) pour détecter un bruit mélangé dans le signal d'entrée; et
- un moyen d'interpolation (8) qui fixe une période d'interpolation en accord avec un résultat de détection du moyen de détection de bruit (7) et, en cas de jugement que le bruit est un bruit court à l'intérieur d'un temps de retard des moyens de stockage (6), engendre et délivre un signal d'interpolation formé par approximation linéaire d'un signal d'entrée retardé par les moyens de stockage (6) pendant la période d'interpolation,

**caractérisé en ce**
**que** le moyen d'interpolation (8)

- lorsqu'il juge que le bruit est un bruit prolongé qui excède le temps de retard des moyens de stockage (6), maintient un signal d'entrée retardé par les moyens de stockage (6), et engendre et délivre un signal d'interpolation d'un niveau constant pendant une période qui dure depuis un point de départ de la période d'interpolation jusqu'à la détection d'un point final du bruit en accord avec un résultat de détection du moyen de détection de bruit (7),
- ultérieurement, engendre et délivre un signal d'interpolation formé par approximation linéaire d'un signal d'entrée retardé par les moyens de stockage (6) jusqu'à un point final de la période d'interpolation, et
- pendant des périodes autres que la période d'interpolation, délivre à titre de signal de sortie un signal d'entrée qui est une sortie retardée des moyens de stockage (6).

2. Dispositif suppresseur de bruit selon la revendication 1,
dans lequel les moyens de stockage (6) et le moyen de détection de bruit (7) reçoivent à titre de signal d'entrée un signal de réception engendré dans un récepteur, et
dans lequel le moyen d'interpolation (8) juge un niveau du signal d'entrée en accord avec un signal de sensibilité de réception détecté dans le récepteur.

3. Procédé de traitement d'un suppresseur de bruit (5) qui supprime un bruit mélangé dans un signal d'entrée et délivre un signal de sortie via des moyens de stockage (6) qui retardent le signal d'entrée d'un temps prédéterminé,
le procédé de traitement comprenant les étapes suivantes:

- une étape de détection de bruit (7) pour détecter un bruit mélangé dans le signal d'entrée; et
- une étape d'interpolation qui fixe une période d'interpolation en accord avec un résultat de détection de l'étape de détection de bruit et, lorsqu'on juge que le bruit est un bruit court à l'intérieur d'un retard temporel des moyens de stockage (6), on engendre et on délivre un signal d'interpolation formé par approximation linéaire d'un signal d'entrée retardé par les moyens de stockage (6) pendant la période d'interpolation,

**caractérisé en ce**
**que** le procédé comprend en outre les étapes suivantes:

- lorsqu'on juge que le bruit est un bruit prolongé qui excède le temps de retard des moyens de stockage (6), on maintient un signal d'entrée retardé par les moyens de stockage (6) et on engendre et on délivre un signal d'interpolation d'un niveau constant pendant une période qui dure depuis un point de départ de la période d'interpolation jusqu'à ce qu'on détecte un point final du bruit en accord avec un résultat de détection de l'étape de détection de bruit,
- ultérieurement, on engendre et on délivre un signal d'interpolation formé par approximation linéaire d'un signal d'entrée retardé par les moyens de stockage (6) jusqu'à un point final de la période d'interpolation, et
- pendant des périodes autres que la période d'interpolation, on délivre à titre de signal de sortie un signal d'entrée qui est une sortie retardée des moyens de stockage (6).

## *FIG.1 (a)*

```
            ┌─────────────────┐
            │     BUFFER      │ ～4
            │     MEMORY      │
            └─────────────────┘
   1                 │
    ↘      3～┌─────────────────┐
 Sin         │  INTERPOLATION  │        Sout
  ○───●──────│ PROCESSING UNIT │─────────○
     │       └─────────────────┘
     │                │ ～GT
     │       ┌─────────────────┐
     └───────│  NOISE PERIOD   │ ～2
             │ DETECTING UNIT  │
             └─────────────────┘
```

## *FIG.1 (b)*

*PRIOR ART*

# FIG.2

## FIG.3 (a)

## FIG.3 (b)

*FIG.4*

# FIG.5

```
                    ( START )
                        │
                        ▼                          ST2
                      ST1        NO        ┌──────────────┐
         ╱ NOISE START POINT ts ╲─────────▶│   Sind IS    │──┐
         ╲ HAS BEEN DETECTED ?  ╱          │  OUTPUTTED   │  │
                        │ YES              └──────────────┘  │
                        ▼                                    │
                ┌──────────────┐  ST3                        │
                │    i = 0     │                             │
                └──────────────┘                             │
                        │    ST4                             │
                        ▼                                ST6 │
         ╱  NOISE END POINT te    ╲    NO    ┌──────────────┐│
         ╱ HAS BEEN DETECTED WITHIN ╲───────▶│   i = i + 0  │◀──┐
         ╲ A PREPARATION PERIOD TPR ?╱       └──────────────┘   │
                        │ YES   ST5                  │    ST7    │
                        ▼                            ▼           │
         ┌──────────────────────┐     ┌───────────────────────┐ │
         │ A LINEARLY APPROXIMATED│    │ AN INTERPOLATION SIGNAL CA│
         │ INTERPOLATION SIGNAL CB│    │ HAVING A CONSTANT LEVEL IS│
         │   IS OUTPUTTED WITHIN  │    │   OUTPUTTED DURING iTH    │
         │ AN INTERPOLATION PERIOD Tc│ │ PREPARATION PERIOD TPRi   │
         └──────────────────────┘     └───────────────────────┘ │
                        │                         │    ST8        │
                        │                         ▼               │
                        │          ╱  A NOISE END POINT te HAS ╲  │
                        │          ╱ BEEN DETECTED WITHIN ITH   ╲─┘ NO
                        │          ╲ PREPARATION PERIOD TPRii ? ╱
                        │                    │ YES   ST9
                        │                    ▼
                        │     ┌───────────────────────┐
                        │     │  A LINEARLY APPROXIMATED│
                        │     │  INTERPOLATION SIGNAL CB│
                        │     │ IS OUTPUTTED WITHIN A REAR│
                        │     │ INTERPOLATION PERIOD Tcb │
                        │     └───────────────────────┘
                        │                    │
                        └────────────────────┘
```